# FASCICULE DE BREVET EUROPEEN

(11) **EP 2 173 030 B1**
(45) Date de publication et mention de la délivrance du brevet: **27.08.2014**
(21) Numéro de dépôt: 09166008.4
(22) Date de dépôt: 21.07.2009
(51) Int. Cl.: H03D 7/16

(54) **Procédé d'extension de la dynamique d'une mémoire numérique de radiofréquences**
Erweiterungsverfahren der Dynamik eines digitalen Speichers von Radiofrequenzen
Method for extending the dynamics of a digital radio frequency memory

(30) Priorité: 25.07.2008 FR 0804254
(43) Date de publication de la demande: 07.04.2010
(73) Titulaire: Thales, 92200 Neuilly Sur Seine (FR)
(72) Inventeur: Quentin, Patrick, 78180, MONTIGNY LE BRETONNEUX (FR); Saada Renaud, 75006, PARIS (FR)
(74) Mandataire: Esselin, Sophie

(56) Documents cités:
- WO-A-01/39385
- US-A- 5 617 060
- US-A1- 2004 130 666

## Description

La présente invention se rapporte à un procédé d'extension de la dynamique d'une mémoire numérique de radiofréquences.

Certaines applications des mémoires numériques de radiofréquences, c'est-à-dire de très hautes fréquences, couramment dénommées « DRFM » (Digital Radio Frequency Memory) nécessitent un fonctionnement très rapide, par exemple à des fréquences de l'ordre de 1 à 3 GHz. Les convertisseurs analogique numérique (ADC) actuellement disponibles pour de telles fréquences ont une résolution (et donc une dynamique) limitée, de l'ordre de 8 à 10 bits, en fonction de la fréquence de fonctionnement.

Le problème est actuellement résolu :
- soit par un CAG (Contrôle Automatique de Gain) analogique, mais le temps de réponse pour des impulsions courtes (moins de 1 µs) est trop important,
- soit par une commutation de gains fixes contrôlés en général par logiciel, mais cette solution présente une faible réactivité pour un fonctionnement en temps réel,
- soit en utilisant en amont plusieurs convertisseurs analogique-numérique en parallèle travaillant sur des dynamiques décalées, mais une telle solution a un coût et encombrement élevés, et nécessite la fusion des différents flots de données provenant des différents convertisseurs.

On connait d'après les documents WO 01/39385 A et US-A-5 617 060 des systèmes de téléphonie cellulaire, mais ils ne suggèrent aucun moyen permettant l'augmentation de la dynamique d'une DRFM fonctionnant à des fréquences très élevées.

La présente invention a pour objet un procédé d'extension de la dynamique d'une mémoire numérique de radiofréquences permettant d'obtenir une dynamique supérieure à celle du convertisseur analogique-numérique branché en amont de son entrée, et ce, sans saturations perturbatrices ni création d'harmoniques ou de raies parasites.

La présente invention a également pour objet l'ensemble comportant un étage analogique récepteur de radiofréquences suivi d'une mémoire numérique de radiofréquences ne présentant pas les inconvénients cités ci-dessus.

Le procédé conforme à l'invention, appliqué à un étage analogique récepteur de radiofréquences, fonctionnant dans une bande de fréquences utiles déterminée, suivi d'un convertisseur analogique-numérique et de la mémoire numérique de radiofréquences, est **caractérisé en ce qu**'on transpose en fréquence intermédiaire un signal d'entrée à porteuse analogique, qu'on applique la saturation à un amplificateur recevant ce signal d'entrée transposé dans la partie haute de la dynamique du spectre reçu, et à une fréquence intermédiaire telle que toutes ses fréquences harmoniques soient plus élevées que la fréquence supérieure du spectre utile et en ce et qu'on filtre le signal de sortie de cet amplificateur pour en éliminer les harmoniques.

Le dispositif conforme à l'invention est un dispositif d'extension de la dynamique d'une mémoire numérique de radiofréquences, appliqué à un étage analogique récepteur de radiofréquences, fonctionnant dans une bande de fréquences utiles déterminée, suivi d'un convertisseur analogique-numérique et de la mémoire numérique de radiofréquences, et il est **caractérisé en ce qu**'il comporte, entre un premier mélangeur de fréquences et un second mélangeur de fréquences, un amplificateur à saturation dynamique haute suivi d'un filtre passe-bande.

Ainsi, l'invention consiste à faire travailler une DRFM à haute fréquence d'échantillonnage dans une dynamique supérieure à celle de son convertisseur analogique-numérique, les harmoniques ainsi créées étant facilement filtrées, car en dehors de la bande utile.

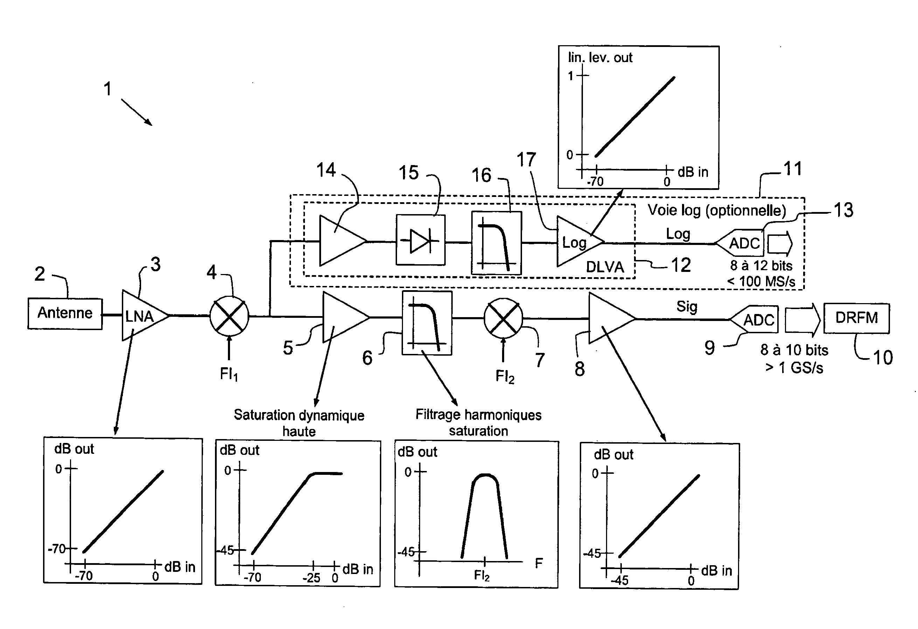

La présente invention sera mieux comprise à la lecture de la description détaillée d'un mode de réalisation, pris à titre d'exemple non limitatif et illustré par le dessin annexé, sur lequel :
- la figure unique est un bloc-diagramme simplifié d'un dispositif de mise en oeuvre du procédé de l'invention.

La présente invention est décrite ci-dessous en référence à une chaîne de réception de signaux hertziens, située en amont de la DRFM et destinée à recevoir des signaux dont la fréquence porteuse analogique est située, par exemple, entre 1 et 3 GHz, mais il est bien entendu que l'invention n'est pas limitée à cette application, et qu'elle peut être mise en oeuvre pour la réception de signaux diffusés autrement que par voie hertzienne et quel que soit leur contenu.

L'étage 1 de réception schématisé sur la figure unique du dessin est relié à une antenne de réception 2. L'antenne 2 est suivie d'un préamplificateur 3 à courbe de réponse linéaire à faible bruit relié à une entrée d'un mélangeur 4 recevant sur son autre entrée une première fréquence intermédiaire FI₁. La sortie du mélangeur 4 est reliée à un amplificateur 5 à saturation dynamique haute suivi d'un filtre passe-bande 6 de fréquences harmoniques hautes. La sortie du filtre 6 est reliée à une entrée d'un second mélangeur 7 dont l'autre entrée reçoit une seconde fréquence intermédiaire FI₂. La sortie du mélangeur est reliée via un amplificateur 8 à courbe de réponse linéaire à un convertisseur analogique-numérique 9 dont la sortie numérique est reliée à l'entrée de la mémoire DRFM 10.

De façon optionnelle, la sortie du mélangeur 4 est également reliée à une voie logarithmique 11 comprenant un amplificateur vidéo logarithmique et détecteur 12 suivi d'un convertisseur analogique-numérique 13. La chaîne amplificatrice 12, (généralement dénommée DLVA, soit « Detector Logarithmic Video Amplifier ») comporte ici un amplificateur 14 suivi, dans l'ordre, d'un détecteur 15, d'un filtre passe-bas 16 et d'un amplificateur vidéo 17 de type logarithmique.

Près de chacun des éléments 3, 5, 6, 8 et 17, on a schématisé la courbe de réponse correspondante. Pour les éléments 3, 5, 8, les courbes sont du type log-log (abscisses et ordonnées en dB), pour l'élément 17, la courbe est du type linéaire-log (entrée en dB et sortie en linéaire), alors que pour le filtre passe-bas 6, la courbe donne le niveau de sortie en dB en fonction de la fréquence.

L'étage de réception 1 conforme à l'invention est similaire à un étage de réception classique, mais il comporte en plus, à la sortie du premier convertisseur 4, l'amplificateur à saturation dynamique 5 suivi du filtre passe-bande 6 dont la fréquence centrale est égale à FI₂ . Ainsi, les harmoniques significatives, qui sont impaires, créées par la saturation de l'amplificateur 5 (étant bien entendu que son signal d'entrée est de niveau suffisant pour le saturer) peuvent être filtrées efficacement, car elles se trouvent en dehors de la bande utile. Cette bande utile de largeur LB est centrée sur FI₂ et a donc pour valeur FI₂ ± LB/2, tandis que les harmoniques impaires occupent respectivement des bandes de 3.( FI₂ ± LB/2), 5.(FI₂ ± LB/2), 7.( FI₂ ± LB/2),... qui sont en dehors de la bande utile.

Ainsi, grâce à l'invention, selon un exemple de réalisation, la mémoire 10 peut avoir une dynamique supérieure d'environ 20dB (en tension) à celle du convertisseur 9, ce convertisseur ayant par exemple une résolution de 8 à 10 bits, et ce, pour un convertisseur fonctionnant à plus de 1 GHz.

On remarquera que la voie logarithmique optionnelle 11 permet d'obtenir à la sortie de l'amplificateur 17 une information de valeur de dynamique absolue, alors que l'information contenue dans la voie numérique principale (en aval du convertisseur 9) a subi une compression dans sa partie haute. Cette information de dynamique absolue peut être utilisée pour reconstituer la vraie dynamique de la voie principale comprimée. Cette information de dynamique peut être délivrée soit sous forme analogique (avant le convertisseur 13), soit sous forme numérique (après le convertisseur 13), et dans ce dernier cas, l'information délivrée par le convertisseur a par exemple une résolution de 8 à 12 bits et peut fonctionner à une fréquence inférieure à 100 MHz.

## Revendications

1. Procédé d'extension de la dynamique d'une mémoire numérique de radiofréquences (DRFM), appliqué à un étage analogique récepteur de radiofréquences (1), fonctionnant dans une bande de fréquences utiles déterminée, suivi d'un convertisseur analogique-numérique (9) et de la mémoire numérique de radiofréquences (10), **caractérisé en ce qu'**on transpose en fréquence intermédiaire un signal d'entrée (2) à porteuse analogique, qu'on applique la saturation à un amplificateur (5) recevant ce signal d'entrée transposé dans la partie haute de la dynamique du spectre reçu, et à une fréquence intermédiaire telle que toutes ses fréquences harmoniques soient plus élevées que la fréquence supérieure du spectre utile et **en ce qu'**on filtre (6) le signal de sortie de cet amplificateur pour en éliminer les harmoniques.

2. Procédé selon la revendication 1, **caractérisé en ce qu'**on détecte (15) et filtre (16) le signal d'entrée transposé, puis on l'amplifie selon une caractéristique logarithmique (17) pour obtenir une information de dynamique absolue du signal d'entrée.

3. Dispositif d'extension de la dynamique d'une mémoire numérique de radiofréquences (DRFM), appliqué à un étage analogique récepteur de radiofréquences (1), fonctionnant dans une bande de fréquences utiles déterminée, suivi d'un convertisseur analogique-numérique (9) et de la mémoire numérique de radiofréquences (10), **caractérisé en ce qu'**il comporte, entre un premier mélangeur de fréquences (4) recevant sur une de ses entrées une radiofréquence provenant de l'antenne, et sur l'autre entrée une première fréquence (FI₁) et un second mélangeur de fréquences (7) une de ses entrées reliée à un filtre passe-bande (6), l'autre entrée recevant une seconde fréquence (FI₂), un amplificateur à saturation dynamique haute (5) suivi du filtre passe-bande (6) dont la fréquence centrale est égale à la seconde fréquence (FI₂).

4. Dispositif selon la revendication 3, **caractérisé en ce qu'**il comporte en outre, un amplificateur vidéo logarithmique et détecteur (12) branché à la sortie du premier mélangeur.

## Patentansprüche

1. Verfahren zur Erweiterung der Dynamik eines digitalen Funkfrequenzspeichers (DRFM), angewendet auf eine analoge Funkfrequenzempfängerstufe (1), mit Funktion in einem bestimmten Band nützlicher Frequenzen, gefolgt von einem Analog-Digital-Wandler (9) und von dem digitalen Funkfrequenzspeicher (10), **dadurch gekennzeichnet, dass** Eingangssignal (2) mit analoger Trägerwelle in Übergangsfrequenz überführt wird, dass die Sättigung auf einen Verstärker (5) angewendet wird, der dieses überführte Eingangssignal im oberen Teil der Dynamik des empfangenen Spektrums empfängt, und auf eine Übergangsfrequenz, die derart ist, dass alle ihre harmonischen Frequenzen höher sind als die obere Frequenz des nützlichen Spektrums und dass das Ausgangssignal dieses Verstärkers gefiltert (6) wird, um daraus die Harmonischen zu entfernen.

2. Verfahren nach Anspruch 1, **dadurch gekennzeichnet, dass** das überführte Eingangssignal ermittelt (15) und gefiltert (16) wird, es danach gemäß einer logarithmischen Charakteristik (17) verstärkt wird, um eine absolute Dynamikinformation des Eingangssignals zu erhalten.

3. Vorrichtung zur Erweiterung der Dynamik eines digitalen Funkfrequenzspeichers (DRFM), angewendet auf eine analoge Funkfrequenzempfängerstufe (1), mit Funktion in einem bestimmten Band nützlicher Frequenzen, gefolgt von einem Analog-Digital-Wandler (9) und von dem digitalen Funkfrequenzspeicher (10), **dadurch gekennzeichnet, dass** sie zwischen einem ersten Frequenzmischer (4), der über einen seiner Eingänge eine Funkfrequenz empfängt, die von der Antenne kommt, und über den anderen Eingang eine erste Frequenz (FI₁) empfängt, und einem zweiten Frequenzmischer (7), der an einem seiner Eingänge mit einem Bandpassfilter (6) verbunden ist, wobei der andere Eingang eine zweite Frequenz (FI₂) empfängt, einen Verstärker mit hoher dynamischer Sättigung (5), gefolgt von dem Bandpassfilter (6), aufweist, dessen zentrale Frequenz der zweiten Frequenz (FI₂) entspricht.

4. Vorrichtung nach Anspruch 3, **dadurch gekennzeichnet, dass** sie ferner einen logarithmischen Videoverstärker und Detektor (12) aufweist, der am Ausgang des ersten Mischers angeschlossen ist.

## Claims

1. A method for extending the dynamics of a digital radio frequency memory (DRFM), applied to an analogue radio frequency receiver stage (1), operating in a determined useful frequency band, followed by an analogue-digital converter (9) and by the digital radio frequency memory (10), **characterised in that** an analogue carrier input signal (2) is transposed into an intermediate frequency, the saturation is applied to an amplifier (5) receiving said transposed input signal in the upper part of the dynamics of the received spectrum and to an intermediate frequency such that all of its harmonic frequencies are higher than the upper frequency of the useful spectrum, and **in that** the output signal of said amplifier is filtered (6) so as to eliminate the harmonics.

2. The method according to claim 1, **characterised in that** said transposed input signal is detected (15) and filtered (16), and is then amplified according to a logarithmic characteristic (17) so as to obtain information relating to the absolute dynamics of the input signal.

3. A device for extending the dynamics of a digital radio frequency memory (DRFM), applied to an analogue radio frequency receiver stage (1), operating in a determined useful frequency band, followed by an analogue-digital converter (9) and by the digital radio frequency memory (10), **characterised in that** it comprises, between a first frequency mixer (4) receiving on one of its inputs a radio frequency coming from the antenna and on the other input a first frequency (FI₁) and a second frequency mixer (7), with one of its inputs being connected to a band-pass filter (6) and the other input receiving a second frequency (FI₂), an amplifier with high-dynamics saturation (5) followed by said band-pass filter (6) for which the central frequency is equal to the second frequency (FI₂).

4. The device according to claim 3, **characterised in that** it further comprises, a detector logarithmic video amplifier (12) connected to the output of said first mixer.
